# EUROPÄISCHE PATENTSCHRIFT

(11) **EP 3 251 127 B1**
(45) Veröffentlichungstag und Bekanntmachung des Hinweises auf die Patenterteilung: **11.01.2023**
(21) Anmeldenummer: 16705892.4
(22) Anmeldetag: 22.01.2016
(51) Int. Cl.: G21K 1/02

(54) **STREUSTRAHLENRASTER**
SCATTERED-RAY GRID
GRILLE ANTIDIFFUSANTE

(30) Priorität: 27.01.2015 AT 182015 U
(43) Veröffentlichungstag der Anmeldung: 06.12.2017
(73) Patentinhaber: Plansee SE, 6600 Reutte (AT)
(72) Erfinder: GLATZ, Wolfgang, 6600 Reutte (AT); KESTLER, Heinrich, 6600 Reutte (AT); TABERNIG, Bernhard, 6600 Pflach (AT)
(74) Vertreter: Ciesla, Bettina
(86) Internationale Anmeldenummer: PCT/AT2016/000004
(87) Internationale Veröffentlichungsnummer: WO 2016/118989

(56) Entgegenhaltungen:
- CA-A- 953 167
- CN-A- 101 934 607
- GB-A- 1 521 129
- GB-A- 1 522 036
- US-A- 5 721 761
- US-A1- 2003 168 980
- US-A1- 2003 222 581
- US-A1- 2005 084 072
- US-A1- 2013 272 505

## Beschreibung

Die vorliegende Erfindung betrifft ein Streustrahlenraster.

Streustrahlenraster (engl. anti-scatter grid) werden bei bildgebenden Verfahren mit Röntgen-, Gamma- oder Teilchenstrahlung eingesetzt, beispielsweise in der Röntgentechnik bei der Bildgebung mittels Röntgenstrahlung oder in der Nukleardiagnostik bei der Anwendung von Gamma-Kameras. Das Streustrahlenraster ist dabei vor dem Strahlungsdetektor (bspw. Röntgenfilm, Gas-, Festkörperdetektor) angeordnet und bewirkt, dass nur Strahlung einer bestimmten Raumrichtung (Primärstrahlung) auf den Detektor gelangt, während das Auftreffen von Streustrahlung auf den Detektor unterdrückt wird.

Streustrahlung entsteht unvermeidlich im Untersuchungsobjekt unter anderem durch Streuung der von einer Strahlungsquelle (z.B. Röntgenquelle) ausgehenden, das Untersuchungsobjekt durchdringenden Primärstrahlung. Während die Primärstrahlung in einer Vorzugsrichtung ausgerichtet ist, ist Streustrahlung ungerichtet und in beliebigen Richtungen zum Detektorsystem orientiert. Streustrahlung ist unerwünscht, da sie eine Rauschquelle darstellt und den Kontrast der Bildaufnahme erheblich verschlechtert. Zur Erzielung einer hohen Bildqualität soll das Streustrahlenraster bezüglich Streustrahlung ein hohes Absorptionsvermögen, bezüglich Primärstrahlung ein hohes Transmissionsvermögen aufweisen und Abschattungen der Primärstrahlung vermeiden.

Streustrahlenraster bestehen aus in regelmäßigen Abständen angeordneten, die entsprechende Strahlung absorbierenden Strukturen, die in Richtung der gewünschten Primärstrahlung ausgerichtet sind und zwischen denen Durchgangskanäle oder Durchgangsschlitze für einen möglichst ungeschwächten Durchgang der Primärstrahlung vorgesehen sind.

Im Stand der Technik sind verschiedene, für unterschiedliche Anwendungszwecke adaptierte Ausführungsformen von Streustrahlenrastern bekannt. Bei Röntgen-Computertomographiegeräten beispielsweise werden bevorzugt Streustrahlenraster eingesetzt, bei denen die strahlungsabsorbierenden Strukturen in Form von Plättchen aus Wolfram- oder Wolfram-Schwermetalllegierungsblechen ausgeführt sind, die mit definierten Abständen zueinander angeordnet sind. Die Durchgangsbereiche zwischen den strahlungsabsorbierenden Plättchen sind offen und aus Stabilitätsgründen beträgt die Dicke der Plättchen üblicherweise ca. 80 bis 100µm. Aufgrund der Plättchendicke treten nachteilige Schatteneffekte der Primärstrahlung auf, wodurch zu einer Bildgebung höhere Röntgendosen erforderlich sind.

In der digitalen Röntgenbildgebung sind zudem lamellenartige Streustrahlenraster bekannt, die aus abwechselnd gestapelten dünnen Streifen (Lamellen) aus stark röntgenstrahlabsorbierendem Material wie Blei und dünnen Streifen aus röntgenstrahldurchlässigem Material wie beispielsweise Papier gebildet sind. Ein derartiges Streustrahlenraster in Lamellenform ist in EP1280165B1 offenbart. Die strahlungsdurchlässigen Lamellen aus beispielsweise Papier fungieren dabei als Abstandshalter (engl. Spacer) zwischen den dünnen Bleifolien, die typischerweise eine Schichtdicke von ca. 20 bis 50µm aufweisen und parallel zur Richtung der Primärstrahlung ausgerichtet sind. Durch die Verwendung von Abstandshalterlamellen kann die strahlungsabsorbierende Blei-Lamelle verhältnismäßig dünn ausgeführt werden, allerdings ist die minimale Dicke der Bleifolien aus fertigungstechnischen Gründen auf ca. 15 bis 30µm beschränkt, wodurch die Primärstrahlung auch teilweise mitabgeschirmt wird. Besonders nachteilig bei der Verwendung von Blei sind potentielle Umweltrisiken, die die Verwendung von Blei mit sich bringt. In der Industrie besteht daher aus Umweltschutzgründen großer Bedarf nach einer Alternativlösung zu Blei.

US20030081731 offenbart ein Streustrahlenraster, bei dem ein stereolithographisch aus einem strahlungsdurchlässigen Polymermaterial gefertigter gitterförmiger Grundkörper mit einer strahlungsabsorbierenden Metallschicht beschichtet wird. In einem zusätzlichen Fertigungsschritt muss die Metallschicht an den Stirnseiten des Streustrahlenrasters weggeätzt werden. Die US2013272505A beschreibt ein dreidimensionales fokussierendes Anti-Streu-Raster und dessen Herstellung. Die US5721761A beschreibt ein aus Röntgenstrahlen absorbierenden Lamellen bestehendes radiografisches Gitter. Die GB1522036A beschreibt eine Entladungslampe mit einer Wolfram beschichteten Molybdänfolie. Die US2003222581A1 beschreibt Hochdruck Quecksilber Lampen. Hier wird eine Metall-Beschichtung auf Kieselerde erwähnt. Die CA953167A beschreibt Iridium beschichtete Rasierklingen. Die CN 101934607A beschreibt eine Kupfer-Aluminium Folie. Diese kann auch für Abschirmung verwendet werden. Die US2005084072A1 beschreibt einen Kollimator, welcher aus mehreren Metallfolien hergestellt ist. GB1521129A beschreibt ebenfalls eine Gasentladungslampe mit einer Wolfram beschichteten Molybdänfolie. US2003168980 offenbart auch eine Gasentladungslampe mit einer Molybänfolie im Dichtungsbereich.

Aufgabe der Erfindung ist, ein Streustrahlenraster zur Abschirmung von Röntgen- und/oder Gammastrahlung zur Verfügung zu stellen, bei dem die Verwendung von Blei vermieden wird und eine Abschattung der Primärstrahlung möglichst gering ist.

Die Aufgabe wird durch ein Streustrahlenraster gemäß Anspruch 1 gelöst. Vorteilhafte Weiterbildungen der Erfindung sind in den Unteransprüchen angegeben.

Das erfindungsgemäße Streustrahlenraster wird aus einem Stapel aus alternierend angeordneten ersten und zweiten Lamellen gebildet. Die erste Lamelle ist Röntgen- und/oder Gammastrahlung absorbierend und aus einer Schichtanordnung gefertigt, welche ein folienartiges Substrat aus einem Molybdän-basierten Werkstoff und mindestens eine Beschichtungsschicht aus einem Wolfram-basierten Werkstoff aufweist, wobei der Werkstoff der Beschichtungsschicht von demjenigen des folienartigen Substrats abweicht. Die zweite Lamelle ist aus einem im Wesentlichen Röntgen- und/oder Gammastrahlung durchlässigen Werkstoff gefertigt.

Mit Werkstoff auf Basis von Molybdän bzw. Wolfram wird auf das entsprechende reine Metall oder eine Legierung des Metalls, die zu mindestens 50 Gew.% (Gewichtsprozent) aus dem betreffenden Metall besteht, Bezug genommen. Insbesondere besteht die Legierung zu mindestens 90 Gew. % aus dem betreffenden Metall. Im Falle einer Legierung enthält der Werkstoff neben dem betreffenden Metall noch weitere Metalle oder auch zu geringen Anteilen nichtmetallische Zusätze, wie beispielsweise Oxide, und/oder Dotierungen.

Als folienartiges Substrat für die Beschichtungsschicht(en) kommen Trägerfolien aus Molybdän bzw. dessen Legierungen zur Anwendung.

Als Substratwerkstoff wird verwendet Molybdän bzw. dessen Legierungen mit aufs Materialvolumen bezogen guten Strahlungsabsorptionseigenschaften, d.h. hoher Dichte und hoher Ordnungszahl, wobei bei der Materialauswahl auch die Material- und Herstellungskosten des folienartigen Substrats und die Verträglichkeit mit dem Beschichtungswerkstoff mit zu berücksichtigen sind.

Trägerfolien aus einem Werkstoff auf Basis von Molybdän werden aufgrund der guten Strahlungsabsorptionseigenschaften von Molybdän verwendet.

Der in der Beschichtungsschicht verwendete Wolfram-basierte Werkstoff hat eine hohe Dichte und hohe Ordnungszahl und hat somit einen auf das Materialvolumen bezogen hohen Absorptionskoeffizienten gegenüber Röntgenstrahlung bzw. Gammastrahlung.

Die Röntgen- und/oder Gammastrahlung absorbierende Lamelle weist also einen schichtförmigen Aufbau auf, wobei sich die Beschichtungsschicht(en) bevorzugt über die gesamte flächige Ausdehnung des folienartigen Substrats erstrecken. In Unterschied zu US20030081731, wo eine strahlungsundurchlässige Schicht auf einen Grundkörper aus einem strahlungsdurchlässigen Material aufgebracht wird, wird bei der vorliegenden Erfindung ein im Wesentlichen strahlungsundurchlässiges Substrat beschichtet. Die Lamelle zeichnet sich daher durch ein hohes Strahlungsabsorptionsvermögen aus, da sowohl das folienartige Substrat als auch die Beschichtungsschicht der Lamelle zur Strahlungsabschirmung beitragen. Durch die Wahl eines Substrat- und Beschichtungswerkstoffs mit hohem Strahlungsabsorptionskoeffizienten lassen sich bei geforderter Streustrahlenabsorption Lamellen mit äußerst geringer Dicke realisieren, wodurch eine unerwünschte Absorption der Primärstrahlung gering gehalten werden kann.

Vorteilhaft ist, dass durch den schichtförmigen Aufbau Wolfram mit großen Strahlungsabsorptionskoeffizienten, das sich mechanisch schlecht umformen lässt, aber mittels eines Beschichtungsverfahren aufgebracht werden kann, genützt werden kann. Wolfram hat gegenüber Blei auf das Materialvolumen bezogen ein deutlich höheres Absorptionsvermögen hinsichtlich Röntgen- und Gammastrahlung, lässt sich aber auf wirtschaftlich vernünftige Weise nicht in Form einer dünnen Bandfolie mit einer Dicke von etwa 15 bis 30µm, wie sie für eine Streustrahlenrasterlamelle benötigt wird, walzen. Wolfram ist daher ein besonders bevorzugter Wolfram-basierter Beschichtungswerkstoff für die Lamelle.

In einer vorteilhaften Ausgestaltung ist der (auf das Materialvolumen bezogene) Röntgen- bzw. Gammastrahlungsabsorptionskoeffizient des Substratwerkstoffs kleiner ist als der Absorptionskoeffizient des Werkstoffs der Beschichtungsschicht(en). Zur Erzielung einer höheren effektiven Streustrahlenabsorption der Lamelle wird die kostengünstige Trägerfolie mit einem Wolfram-basierten Beschichtungswerkstoff mit höherem Absorptionsvermögen, wie Wolfram, beschichtet.

Das folienartige Substrat kann einseitig mit mindestens einer Beschichtungsschicht beschichtet sein. Eine einseitige Beschichtung bietet sich insbesondere bei Beschichtungsverfahren wie physikalische Gasphasenabscheidung (PVD, engl. physical vapour deposition), chemische Gasphasenabscheidung (CVD, engl. chemical vapour deposition), thermische Spritzverfahren oder Slurryverfahren an, bei denen in einem Prozessschritt nur eine Substratseite beschichtet wird. PVD-Verfahren sind besonders vorteilhaft, da sich damit sehr dichte Schichten abscheiden lassen.

In einer vorteilhaften Ausführungsform kann das folienartige Substrat auch beidseitig mit mindestens einer Beschichtungsschicht beschichtet sein. In einer beidseitig beschichteten Ausführungsform ist an beiden Seitenflächen des folienartigen Substrats mindestens eine Beschichtungsschicht aufgebracht, in diesem Fall besteht die Schichtanordnung der Lamelle aus mindestens drei Schichten, wobei die mittlere Schicht das folienartige Substrat ist. Beidseitig beschichtete folienartige Substrate lassen sich beispielsweise mittels galvanischer Verfahren, beispielsweise in einem Schmelzbad mittels Hochtemperatur-Schmelzflusselektrolyse, herstellen. Bevorzugt besteht die Beschichtungsschicht an den beiden Seitenflächen des Substrats aus dem gleichen Wolfram-basierten Werkstoff. Ein derart beidseitig beschichtetes Substrat bietet den Vorteil, dass Verbiegungen der Lamelle, die aufgrund einer Differenz des thermischen Ausdehnungskoeffizienten zwischen Substrat- und Beschichtungswerkstoff bei Temperaturänderungen auftreten können, reduziert werden.

Gemäß einer bevorzugten Ausführungsform beträgt die Dicke der ersten Lamelle zwischen 10µm und 60µm, insbesondere zwischen 15 µm und 30µm. In dieser Stärke hat eine beschichtete Folie eine für den mechanischen Fertigungsprozess der Lamelle ausreichende Eigenstabilität. Da als Beschichtungswerkstoff Wolfram oder eine Wolfram Legierung eingesetzt wird, können die Lamellen aufgrund des hohen Strahlenabsorptionskoeffizienten von Wolfram besonders dünn ausgelegt werden. Eine möglichst dünne Ausführung der Lamelle ist hinsichtlich negativer Abschirmung- und Abschattungseffekte der Primärstrahlung äußerst wünschenswert.

Erfindungsgemäß ist eine Schichtanordnung mit einem folienartigen Substrat aus einem Molybdän-basierten Werkstoff, das mit einem Wolfram-basierten Werkstoff ein- oder beidseitig beschichtet ist. Mit Wolfram-basiertem Werkstoff wird auf reines Wolfram oder auf eine Wolfram-Legierung, die zumindest 50 Gew.%, insbesondere zu 90 Gew. %, aus Wolfram besteht, Bezug genommen. Im Falle einer Wolfram Legierung weist diese noch weitere Metalle, beispielsweise Rhenium, auf. Analog wird mit Molybdän-basiertem Werkstoff auf reines Molybdän oder auf eine Molybdän Legierung Bezug genommen, die zumindest 50 Gew. %, insbesondere zumindest 90 Gew. % Molybdän aufweist und gegebenenfalls weitere Metalle bzw. zu geringen Anteilen nicht-metallische Zusätze und/oder Dotierungen enthält.

Zur Fertigung der Lamelle wird eine dünne Metallfolie aus Molybdän auf eine Dicke von etwa 10µm bis 25µm gewalzt und vor dem Beschichtungsprozess gegebenenfalls noch elektrochemisch vorbehandelt oder durch Beizen für die Beschichtung konditioniert. Die Metallfolie wird in einer PVD-Beschichtungsanlage, insbesondere in einer Rolle-zu-Rolle Beschichtungsanlage, mit Wolfram beschichtet. Bevorzugt beträgt die Dicke der Wolframschicht zwischen 5 und 25µm, insbesondere zwischen 5 und 15µm. Das Ausgangsmaterial für die Lamelle lässt sich als Metallfolienband fertigen, das zu einem Coil wickelbar ist. Die Materialkombination Molybdän-Wolfram ist besonders vorteilhaft, da auch der Trägerwerkstoff Molybdän Röntgen- bzw. Gammastrahlung effektiv absorbiert und somit in Kombination mit der stark strahlungsabsorbierenden Wolframschicht aufs Materialvolumen bezogen eine äußerst wirkungsvolle Strahlungsabschirmung erzielt werden kann. Um dieselbe Streustrahlenabsorptionsleistung zu erzielen, kann eine Streustrahlenrasterlamelle aus Molybdän-Wolfram im Vergleich mit einer Blei-Lamelle aufgrund der auf das Materialvolumen bezogen höheren Strahlungsabsorption mit geringerer Dicke dimensioniert werden. Durch die geringere Lamellendicke ist die unerwünschte Absorption der Primärstrahlung (bei gleicher Streustrahlungsabsorption) geringer. Die Wolframschicht zeichnet sich zudem durch eine hohe Haftfähigkeit auf der Molybdän-Folie aus. Generell sind sich die beiden Metalle Molybdän und Wolfram in ihren physikalischen und chemischen Eigenschaften sehr ähnlich, beispielsweise haben sie einen vergleichbaren Temperaturausdehnungskoeffizienten. Die Ähnlichkeit im Temperaturausdehnungskoeffizienten verhindert beispielsweise bei den beim Beschichtungsprozess auftretenden thermischen Belastungen temperaturinduzierte Spannungen bzw. Verbiegungen, wie sie bei einem Bimetallstreifen aus Metallen mit unterschiedlichem Temperaturausdehnungskoeffizienten auftreten würden. Der folienartige Molybdän-Wolframwerkstoffverbund weist zudem im Vergleich zu einer Bleifolie eine höhere Steifigkeit und Festigkeit auf, wodurch Lamellen mit einer im Vergleich zu einer Blei-Lamelle höherer Eigenstabilität erzielbar sind. Ferner wird ein Herstellverfahren zur Herstellung einer Röntgen- und/oder Gammastrahlung absorbierenden Lamelle offenbart, dass jedoch nicht Teil der beanspruchten Erfindung ist. Dazu wird in einem ersten Verfahrensschritt eine dünne Folie aus einem Molybdän-basierten Werkstoff durch bekannte Umformverfahren wie Walzen, etc. gefertigt. Als Ausgangsbasis für die Lamelle kann insbesondere eine Folie auf Basis von Molybdän verwendet werden. Typischerweise beträgt die Dicke der Folie zwischen 5µm und 30µm, bevorzugt zwischen 10µm und 25µm. Die Folie wird anschließend mit einem metallischen Werkstoff auf Basis von Wolfram beschichtet. Der Werkstoff der Beschichtungsschicht unterscheidet sich vom Werkstoff der Folie. Diese Beschichtungswerkstoffe zeichnen sich durch einen hohen Strahlungsabsorptionskoeffizienten aus. Bevorzugt wird eine Beschichtungsschicht mit einer Dicke zwischen 5µm und 50µm, insbesondere zwischen 5µm und 20µm, aufgebracht. Als Beschichtungsverfahren kommen dem Fachmann bekannte Verfahren wie physikalische Gasphasenabscheidung (PVD), chemische Gasphasenabscheidung (CVD), thermische Spritzverfahren, Slurryverfahren oder galvanische Verfahren wie Hochtemperatur-Schmelzflusselektrolyse in Betracht. Für aufgebrachte Schichten mit einer Schichtdicke größer als etwa 20µm sind galvanische Verfahren gegenüber Gasphasenabscheidungsverfahren zu bevorzugen.

Die Folie kann optional vor dem Beschichtungsprozess in einem Zwischenschritt noch für den Beschichtungsvorgang vorbereitet werden (durch Beizen bzw. elektrochemische Konditionierung). Die so erhaltene beschichtete Metallfolie lässt sich zu einem Coil wickeln und im Fertigungsprozess für einen Streustrahlenraster einsetzen, wo es in eine entsprechende Streifenform geschnitten wird. Es werden durch das Herstellungsverfahren die oberhalb in Bezug auf die Lamelle erläuterten Vorteile erzielt.

Die Röntgen- und/oder Gammastrahlung absorbierende Lamelle dient zur Absorption der Streustrahlung und wird alternierend mit sogenannten Abstandhalterlamellen aus Röntgen- bzw. Gammastrahlung durchlässigem Material (engl. spacer material) in bekannter Weise zu einem Streustrahlenraster in Lamellenform assembliert. Dabei wird das als Coil vorliegende beschichtete Metallfolienband (typischerweise mit einer Länge von etwa 50 m oder mehr und einer Breite im Bereich mehrerer cm, beispielsweise etwa 3 bis 5 cm) in einer geeigneten Schneidvorrichtung in Streifenform vorgeschnitten, ein derartiger Streifen ist je nach Anwendung und Fertigungsprozess typischerweise etwa 15 bis 20 cm lang und etwa 3 cm breit. Diese strahlungsabsorbierenden Lamellen werden abwechselnd mit streifenförmigen Abstandshalterlamellen (beispielsweise aus Papier, einem Faserverbundstoff oder aus Kunststoffen wie Polyethylen, Polystyrol oder Polypropylen) in einer Stapelvorrichtung gestapelt, wobei bei der Ausrichtung der einzelnen Lamellen eine geforderte Fokusausrichtung auf einen Konvergenzpunkt (Strahlungsquelle) zu berücksichtigen ist. Der Stapel mit den einzelnen Lamellen kann mit einem geeigneten Klebstoff wie beispielsweise Epoxidharz verklebt, unter Wärmeeinwirkung fixiert und anschließend in einzelne Streustrahlenraster geschnitten werden. Es sind aber auch Ausführungsformen des Streustrahlenrasters denkbar, bei denen der Lamellenstapel ohne Klebstoff nur durch Zusammenpressen in einem entsprechenden Rahmen zusammengehalten wird.

Das erfindungsgemäße Streustrahlenraster wird auch als 1-dimensionales Streustrahlenraster bezeichnet, da eine 1-dimensionale Kollimierung der auf das Streustrahlenraster auftreffenden Strahlung erzielt wird.

Die Erfindung wird nachfolgend anhand der Zeichnungen näher erläutert.

Es zeigen:
- Fig. 1:: eine schematische Querschnittdarstellung eines Streustrahlenrasters bei Verwendung in einer Röntgenanlage;
- Fig. 2:: eine dreidimensionale Darstellung einer Röntgenstrahlung-absorbierende Lamelle für eine erste Ausführungsform der Erfindung;
- Fig. 3:: eine dreidimensionale Darstellung einer Röntgenstrahlungabsorbierende Lamelle für eine zweite Ausführungsform der Erfindung;

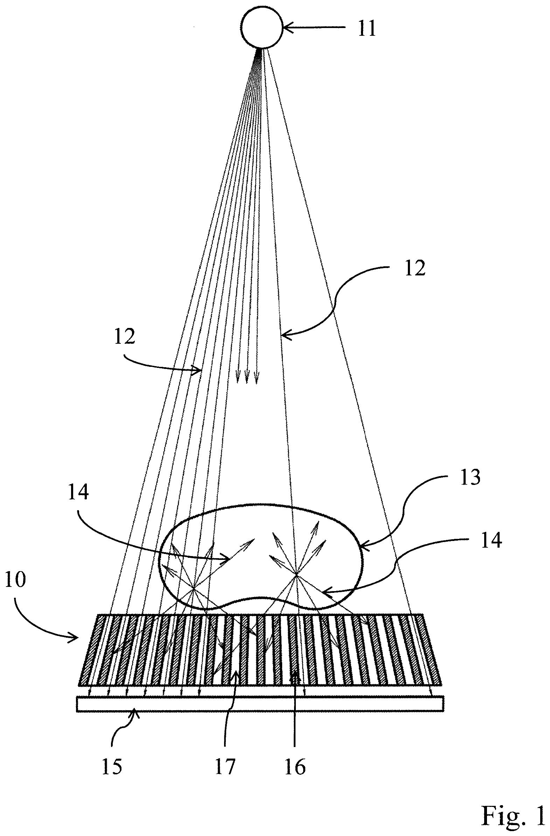

In Fig. 1 ist schematisch ein Streustrahlenraster (10) in einer Röntgenanlage dargestellt. Die in einer Röntgenquelle (11) erzeugte Röntgenstrahlung (Primärstrahlung) (12) trifft auf ein Untersuchungsobjekt (13), beispielsweise einen menschlichen Körper, mit dem es wechselwirkt und wodurch Streustrahlung (14) entsteht. Die durch das Untersuchungsobjekt hindurchtretende Röntgenstrahlung, sowohl Primärstrahlung als auch ungerichtete Streustrahlung, trifft anschließend auf das Streustrahlenraster (10), das in Strahlungsrichtung vor einem Röntgendetektor (15) angeordnet ist. Der Röntgendetektor (15) erfasst die Intensitätsverteilung der auftreffenden Röntgenstrahlung.

Das Streustrahlenraster (10) (in Fig. 1 in einem Querschnitt in einer Ebene senkrecht auf die Längsrichtung der streifenförmigen Lamellen dargestellt) weist eine Vielzahl von streifenförmigen Lamellen auf, wobei alternierend röntgenstrahlabsorbierende Lamellen (16) und röntgenstrahldurchlässige Lamellen (17) angeordnet sind. Die Lamellen (16,17) sind in einer Ebene im Wesentlichen senkrecht zur einfallenden Primärstrahlung und in ihrer Längsrichtung (die Längsrichtung ist senkrecht auf die dargestellte Querschnittsebene) im Wesentlichen parallel angeordnet. Bevorzugt sind die Lamellen (16,17), wie in Fig. 1. angedeutet, auf den Fokus der Röntgenquelle (11) ausgerichtet, d.h. die Lamellen (16,17) sind nicht exakt parallel zueinander, sondern unter einem sehr kleinen Winkel zueinander gekippt, wobei eine Lamelle etwa im Mittelpunkt des Streustrahlenrasters senkrecht zur Ebene des Streustrahlenrasters ausgerichtet ist und die übrigen Lamellen mit zunehmender Entfernung vom Mittelpunkt stärker gekippt sind. Das Streustrahlenraster (10) absorbiert die auf das Streustrahlenraster schräg auftreffende Streustrahlung und lässt Röntgenstrahlung aus der Richtung der Röntgenquelle im Bereich der strahlungsdurchlässigen Lamellen passieren. Das Streustrahlenraster (10) ist in Fig. 1 in einer flachen Ausführungsform dargestellt, es sind aber auch gekrümmte Ausführungsformen, insbesondere in Form eines Zylinderflächenabschnitts, denkbar.

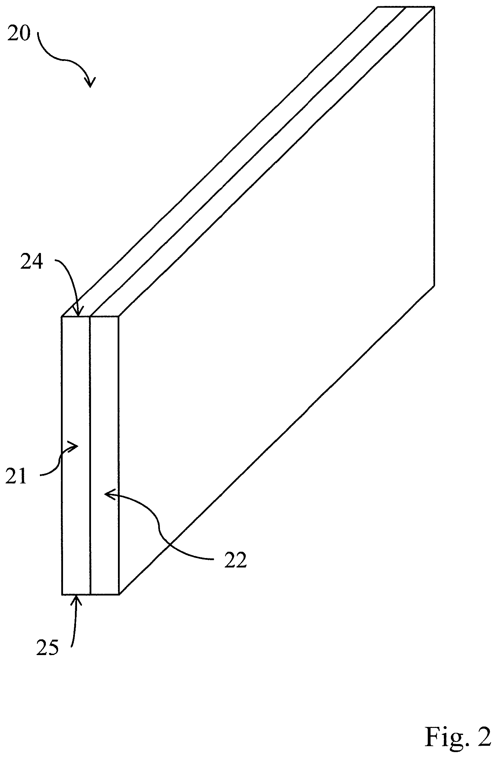

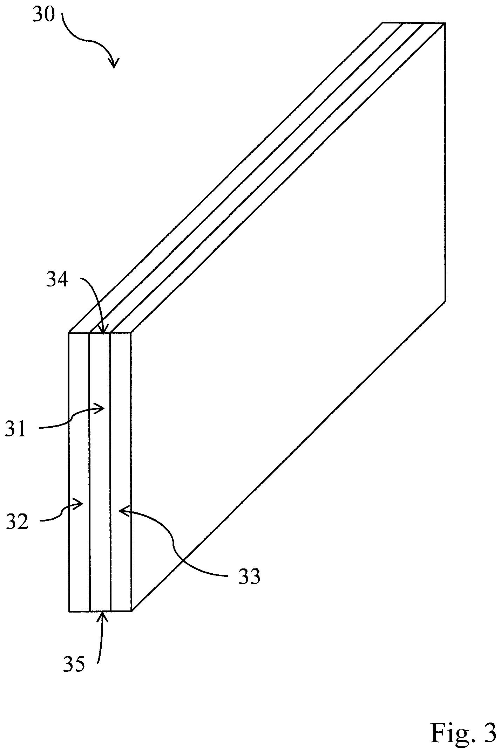

In Fig. 2 und Fig. 3 sind verschiedene röntgenstrahlabsorbierende Lamellen (16; 20; 30) dargestellt. Die röntgenstrahlabsorbierenden Lamellen (16; 20; 30) bestehen aus einer Schichtanordnung mit einem folienartigen Substrat (21; 31), das mit mindestens einer Beschichtungsschicht (22; 32, 33) aus einem Wolfram-basierten Werkstoff beschichtet ist. Als Werkstoff für das Substrat (21; 31) wird ein Molybdänbasierter Werkstoff gewählt, wobei sich der Werkstoff des Substrats von dem der Beschichtungsschicht unterscheidet. Üblicherweise hat der Werkstoff der Beschichtungsschicht auf das Volumen bezogen einen höheren Röntgenstrahlungsabsorptionskoeffizienten als der Werkstoff des folienartigen Substrats. Die Dicke des Substrats (21; 31) bzw. der Beschichtungsschicht (22; 32, 33) sind abhängig vom gewählten Werkstoff und derart dimensioniert, dass die gewünschten Absorptionseigenschaften der Lamelle erzielt werden können. Fig. 2 zeigt eine röntgenstrahlabsorbierende Lamelle (20), bei der das folienartige Substrat (21) auf einer Seite mit einer Beschichtungsschicht (22) beschichtet. In Fig. 3 ist das folienartige Substrat (31) auf beiden Seiten mit jeweils einer Beschichtungsschicht (32, 33) beschichtet. Eine beidseitig beschichtete Lamelle ist zu bevorzugen, wenn zur Erzielung der geforderten Absorptionsleistung eine verhältnismäßig dicke Beschichtungsschicht benötigt wird. Es wird nämlich insbesondere bei Gasphasenabscheidungsverfahren wie PVD mit zunehmender Schichtdicke schwieriger, qualitativ hochwertige Schichten aufzubringen. Wie Fig. 2 und Fig. 3 zu entnehmen ist, erstrecken sich die Beschichtungsschichten in beiden über die gesamte flächige Ausdehnung des Substrats. Es wird dadurch eine wirkungsvolle Abschirmung der Streustrahlung erzielt. Bei Ausführungsformen, bei denen die Beschichtungsschicht (22; 32, 33) Röntgenstrahlung stärker absorbiert als das Substrat (21; 31), ist es vorteilhaft, wenn die Seitenränder (24, 25; 34, 35) des Substrats, die in Einbaulage der Lamelle zur Röntgenquelle zugewandt sind (24;34) bzw. von der Röntgenquelle abweisen (25;35), nicht mit dem stark röntgenstrahlabsorbierenden Beschichtungswerkstoff beschichtet werden und frei bleiben. Dadurch kann eine unerwünschte Absorption der Primärstrahlung, die in diesen Bereichen auf die Lamelle trifft, etwas reduziert werden.

## Patentansprüche

1. Streustrahlenraster (10) für Röntgen- und/oder Gammastrahlung gebildet aus einem Stapel aus alternierend angeordneten ersten und zweiten Lamellen (16, 20, 30; 17), wobei die erste , Röntgen- und/oder Gammastrahlung absorbierende, Lamelle (16; 20; 30) aus einer Schichtanordnung gefertigt ist, welche ein folienartiges Substrat (21; 31) aus einem Molybdän-basierten Werkstoff und mindestens eine Beschichtungsschicht (22; 32, 33) aus einem Wolfram-basierten Werkstoff aufweist, wobei der Werkstoff der Beschichtungsschicht von demjenigen des folienartigen Substrats abweicht, und die zweite Lamelle (17) aus einem im Wesentlichen Röntgen- und/oder Gammastrahlung durchlässigen Werkstoff gefertigt ist.

2. Streustrahlenraster nach Anspruch 1, **dadurch gekennzeichnet, dass** das folienartige Substrat (21; 31) einseitig mit mindestens einer Beschichtungsschicht (22; 32, 33) beschichtet ist.

3. Streustrahlenraster nach Anspruch 1, **dadurch gekennzeichnet, dass** das folienartige Substrat (21; 31) beidseitig mit jeweils mindestens einer Beschichtungsschicht (22; 32, 33) beschichtet ist.

4. Streustrahlenraster nach einem der vorangehenden Ansprüche, **dadurch gekennzeichnet, dass** die erste Lamelle (16; 20; 30) eine Dicke von 10µm bis 60µm aufweist.

5. Verwendung einer Folie, die ein folienartiges Substrat aus einem Molybdän-basierten Werkstoff und mindestens einer Beschichtungsschicht aus einem Wolfram-basierten Werkstoff aufweist, als Röntgen- und/oder Gammastrahlung absorbierende Lamelle in einem Streustrahlenraster gemäß einem der Ansprüche 1 bis 4 .

## Claims

1. An anti-scatter grid (10) for x-ray and/or gamma radiation formed by a stack of alternately arranged first and second slats (16, 20, 30, 17), wherein the first x-ray and/or gamma radiation absorbing slat (16, 20, 30) is produced by a layer arrangement comprising a film-like substrate (21, 31) formed from a molybdenum-based material and at least one coating layer (22, 32, 33) formed from a tungsten-based material **characterized in that** the material of the coating layer is different from the material of the film-like substrate and the second slat (17) is produced from a material that is substantially transmissive to x-ray and/or gamma radiation.

2. The anti-scatter grid according to claim 1 **characterized in that** the film-like substrate (21, 31) is coated on one side with at least one coating layer (22, 32, 33).

3. The anti-scatter grid according to claim 1 **characterized in that** the film-like substrate (21, 31) is coated on both sides with at least one respective coating layer (22, 32, 33).

4. The anti-scatter grid as claimed in one of the preceding claims, **characterized in that** the slat (16, 20, 30) has a thickness of from 10 µm to 60 µm.

5. Use of a film which comprises a film-like substrate of a molybdenum-based material and at least one coating layer of a tungsten-based material as an x-ray and/or gamma radiation absorbing slat as claimed in one of claims 1 to 4 in an anti-scatter grid.

## Revendications

1. Grille antidiffusion (10) pour rayonnement X et/ou gamma, formée d'un empilement de premières et de secondes lames (16, 20, 30 ; 17) disposées en alternance, la première lame (16 ; 20 ; 30) absorbant le rayonnement X et/ou gamma étant fabriquée à partir d'une structure stratifiée qui comprend un substrat (21 ; 31) en forme de feuille constitué d'un matériau à base de molybdène et au moins une couche de revêtement (22 ; 32, 33) constituée d'un matériau à base de tungstène, le matériau de la couche de revêtement étant différent de celui du substrat en forme de feuille, et la seconde lame (17) étant fabriquée à partir d'un matériau pour l'essentiel transparent au rayonnement X et/ou gamma.

2. Grille antidiffusion selon la revendication 1, **caractérisée en ce que** le substrat (21 ; 31) en forme de feuille est revêtu sur une face d'au moins une couche de revêtement (22 ; 32, 33).

3. Grille antidiffusion selon la revendication 1, **caractérisée en ce que** le substrat (21 ; 31) en forme de feuille est revêtu sur chacune de ses deux faces d'au moins une couche de revêtement (22 ; 32, 33).

4. Grille antidiffusion selon l'une des revendications précédentes, **caractérisée en ce que** la première lame (16 ; 20 ; 30) présente une épaisseur de 10 µm à 60 µm.

5. Utilisation d'une feuille qui comprend un substrat en forme de feuille constitué d'un matériau à base de molybdène et d'au moins une couche de revêtement constituée d'un matériau à base de tungstène, en tant que lame absorbant le rayonnement X et/ou gamma dans une grille antidiffusion selon l'une des revendications 1 à 4.
